## Europäisches Patentamt

## European Patent Office

## Office européen des brevets

(19)

(11) Veröffentlichungsnummer: **0 250 611**
**B1**

(12) **EUROPÄISCHE PATENTSCHRIFT**

(45) Veröffentlichungstag der Patentschrift:
**19.12.90**

(51) Int. Cl.⁵: **H01L 21/28**, G03F 7/26

(21) Anmeldenummer: **86108501.7**

(22) Anmeldetag: **21.06.86**

(54) **Verfahren zum Entfernen einer strukturierten Maskierungsschicht.**

(43) Veröffentlichungstag der Anmeldung:
**07.01.88 Patentblatt 88/1**

(45) Bekanntmachung des Hinweises auf die Patenterteilung:
**19.12.90 Patentblatt 90/51**

(84) Benannte Vertragsstaaten:
**DE FR NL**

(56) Entgegenhaltungen:
**EP-A- 0 052 227**
**FR-A- 2 339 954**
**US-A- 4 458 407**
**US-A- 4 528 066**

**INTERNATIONAL ELECTRON DEVICES MEETING 1983,
TECHNICAL DIGEST, Washington, D.C., US, 5.-7.
Dezember 1983, Seiten 757-759, IEEE, New York, US; T,
KURE et al.: "VLSI device fabrication using a unique,
highly-selective Si3N4 dry etching"**

(73) Patentinhaber: **Deutsche ITT Industries GmbH,
Hans-Bunte-Strasse 19 Postfach 840,
D-7800 Freiburg(DE)**

(72) Erfinder: **König, Dietmar, Rosenweg 6, D-7800 Freiburg
i.Br.(DE)**

ACTORUM AG

## Beschreibung

Die Erfindung betrifft ein Verfahren zum Entfernen einer strukturierten Maskierungsschicht, die während der Herstellung eines Halbleiterbauelements zunächst auf einer durch eine Isolierschicht vom Halbleiterkörper getrennten Halbleiterschicht erzeugt, anschließend strukturiert, danach als Ätzmaske zur selektiven Entfernung der Halbleiterschicht und schließlich als Ionenimplantationsmaske verwendet wird.

Bei der Herstellung von Halbleiterbauelementen ist es erforderlich, Maskierungsschichten aus z.B. Siliciumdioxid, Siliciumnitrid oder Metall, die im Verlauf des Verfahrens als Ätz- und/oder Ionenimplantationsmaske oder Diffusionsmaske gedient haben, durch Ätzen wieder zu entfernen. Bei entsprechender Schichtenfolge können unerwünschte Unterätzungen entstehen, in denen sich Schmutzteilchen festsetzen können, was die elektrischen Eigenschaften des Halbleiterbauelements beeinträchtigt. Die Unterätzungen müssen daher in einem gesonderten Verfahrensschritt beseitigt werden, z.B. durch Auffüllen mit Material der geätzten Schicht.

Dieses Problem wird durch die heute bereits üblichen Strukturbreiten (ca. 2 μm), ganz besonders aber durch deren zukünftige weitere Reduzierung (1 μm und kleiner) verschärft. Es werden nämlich Maskierungsschichten verwendet, die den Rand der darunterliegenden Schicht, die z.B. aus Polysilicium bestehen kann, überragen. Soll nun nach, insbesondere durch Ionenimplantation, erfolgter Dotierung und anschließendem Eintreiben eines Dotierstoffs die Maskierungsschicht abgeätzt werden, so ergeben sich wieder die geschilderten Schwierigkeiten. Wird ein Naßätzverfahren durchgeführt, so kommt es z.B. bei einer Schichtenfolge aus Halbleiterkörper, Oxidschicht, Polysilicium- und Maskierungsschicht durch Unterätzen der Polysiliciumschicht zu seitlichen Abtragungen der Oxidschicht. Handelt es sich bei dem Bauelement z.B. um einen Feldeffekttransistor, so wird die Durchschlagsfestigkeit im Gate-Source/Drainbereich herabgesetzt. Die Beseitigung dieser Unterätzungen erfordern aufwendige Maßnahmen, wie z.B. Oxidation oder plasmaunterstützte Ablagerungen, wobei erschwerend wirkt, daß der Auffüllvorgang nur an bestimmten Stellen erfolgen soll.

Die in den Ansprüchen gekennzeichnete Erfindung löst daher die Aufgabe, die Maskierungsschicht so zu entfernen, daß keine Unterätzungen entstehen. Dadurch werden z.B. die Ausbeuten verbessert.

Die Erfindung wird nachstehend anhand der Figuren der Zeichnung näher erläutert.

Fig. 1 zeigt im Schnitt einen während der Herstellung eines Halbleiterbauelements zeitweise auftretenden Zustand,

Fig. 2 zeigt den Zustand von Fig. 1 nach dem Abätzen der Maskierungsschicht, und die Fig. 3 bis 5 zeigen Zustände nach Schritten entsprechend der Erfindung.

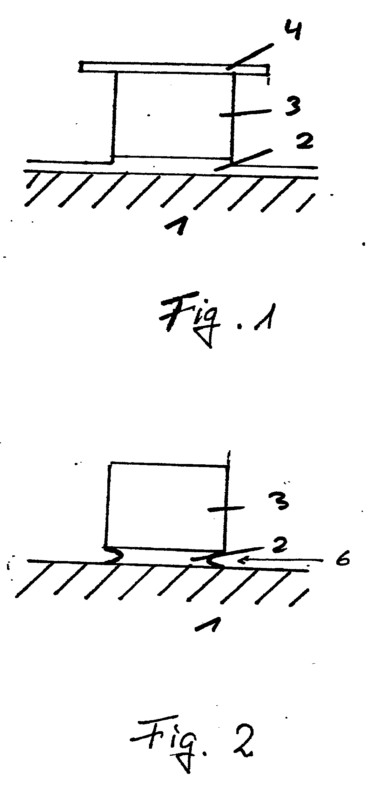

In Fig. 1 ist der Zustand bei der Herstellung eines Halbleiterbauelements gezeigt, das den Halbleiterkörper 1 enthält, auf dem die Isolierschicht 2 aus z.B. Siliciumdioxid aufgebracht ist, die z.B. als Gate-Oxidschicht eines Feldeffekttransistors dienen kann. Auf der Isolierschicht 2 ist die mit Hilfe der Maskierungsschicht 4 bereits strukturierte Halbleiterschicht 3 aus z.B. Polysilicium angeordnet. Durch Ätzen ist dabei erreicht worden, daß die Maskierungsschicht 4 die darunterliegende, die späteren Leitbahnen bildende Halbleiterschicht 3 überragt. Durch den überstehenden Rand erreicht man eine zusätzliche Maskierung des Halbleiterkörpers 1, so daß beim Einbringen von Dotierstoffen durch Ionenimplantation im Abschattungsbereich der überstehenden Maskierungsschichtteile ein schwach dotierter Bereich im Halbleiterkörper 1 entstehe. Wird nun durch Naßätzen die Maskierungsschicht 4 entfernt, so erhält man den in Fig. 2 gezeigten Zustand mit den Ätztaschen 6 und den damit verbundenen und bereits beschriebenen Nachteilen.

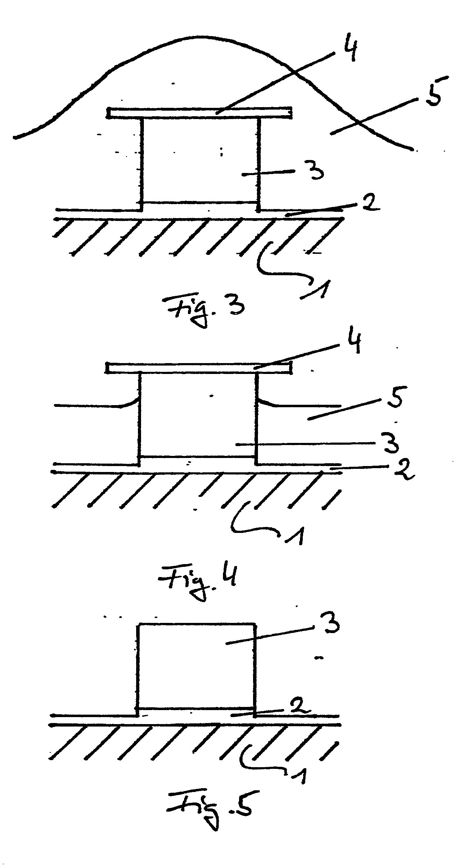

In den Fig. 3 bis 5 sind die einzelnen bei der Erfindung angewandten Schritte an einem Ausführungsbeispiel gezeigt. Zunächst wird, ausgehend von dem in Fig. 1 gezeigten Zustand, die die Maskierungsschicht 4, die Halbleiterschicht 3 und die Isolierschicht 2 enthaltende Oberfläche des Halbleiterkörpers 1 mit der Photolackschicht 5 bedeckt, vgl. Fig. 3. In einem zweiten Schritt wird nun in z.B. einem Sauerstoffplasma die Photolackschicht 5 soweit abgetragen, daß die Maskierungsschicht 4 völlig freigelegt wird, vgl. Fig. 4. Nunmehr wird in einem Naß- oder Trockenätzprozeß die Maskierungsschicht 4 entfernt und anschließend der nach dem Abtragen noch verbliebene Rest der Photolackschicht 4 völlig beseitigt, vgl. Fig. 5. Dabei können die letzten drei Verfahrensschritte z.B. in einem Plasmaoxidätzer aufeinanderfolgend durchgeführt werden.

## Patentansprüche

1. Verfahren zum Entfernen einer strukturierten Maskierungsschicht (4), die während der Herstellung eines Halbleiterbauelements zunächst auf einer durch eine Isolierschicht (2) vom Halbleiterkörper (1) getrennten Halbleiterschicht (3) erzeugt, anschließend strukturiert, danach als Ätzmaske zur selektiven Entfernung der Halbleiterschicht (3) und schließlich als Ionenimplantationsmaske verwendet wird, welches Verfahren die weiteren Verfahrensschritte umfaßt:
- auf der die Isolierschicht (2), die strukturierte Halbleiterschicht (3) und die Maskierungsschicht (4) enthaltenen Oberfläche des Halbleiterkörpers (1) wird eine Photolackschicht (5) aufgebracht;
- diese Photolackschicht (5) wird nur soweit abgetragen, daß die Maskierungsschicht (4) völlig freigelegt wird;
- diese Markierungsschicht (4) wird vollständig entfernt; und
- die verbliebenen Teile der Photolackschicht (5) werden ebenfalls entfernt.

2. Verfahren nach Anspruch 1, dadurch gekennzeichnet, daß die Maskierungsschicht (4) aus Siliciumdioxid, Siliciumnitrid oder einem Metall gebildet wird.

3. Verfahren nach Anspruch 1 oder 2, dadurch gekennzeichnet, daß die Photolackschicht (5) mittels eines Sauerstoffplasmas abgetragen und entfernt wird.

4. Verfahren nach einem der Ansprüche 1 bis 3, dadurch gekennzeichnet, daß die Maskierungsschicht (4) mittels Naß- oder Plasmaätzens entfernt wird.

## Claims

1. Method of removing a patterned masking layer (4) which is at first produced, during the fabrication of a semiconductor device, on a semiconductor layer (3) separated from the semiconductor body (substrate) (1) by an insulating layer (2), then patterned and thereafter used as an etch mask for selectively removing the semiconductor layer (3), and finally as an ion implantation mask, with this method including the following processing steps:
   – on to the surface of the semiconductor body (substrate) (1) containing the insulating layer (2), the patterned semiconductor layer (3) and the masking layer (4), there is deposited a layer of photoresist (5),
   – this layer of photoresist (5) is only removed to such an extent that the masking layer (4) becomes completely exposed,
   – this masking layer (4) is then removed completely, and
   – the remaining parts of the photoresist layer (5) are likewise removed.

2. A method as claimed in claim 1, characterized in that said masking layer (4) is formed either of silicon dioxide, silicon nitride, or of a metal.

3. A method as claimed 1 or 2, characterized in that said layer of photoresist (5) is taken off and removed by means of an oxygen plasma.

4. A method as claimed in one of claims 1 to 3, characterized in that said masking layer (4) is removed by employing either a wet or a dry etching process.

## Revendications

1. Procédé pour éliminer une couche de masquage structurée (4) qui, pendant la fabrication d'un composant semiconducteur, est tout d'abord produite sur une couche semiconductrice (3) séparée du corps (1) du semiconducteur par une couche isolante (2), puis qui est structurée puis utilisée comme masque de gravure pour éliminer sélectivement la couche semiconductrice (3), et qui est enfin utilisée comme masque d'implantation ionique, lequel procédé comprend les étapes supplémentaires consistant en ce que:
   – une couche de laque photosensible (5) est appliquée sur la surface du corps de semiconducteur (1) qui contient la couche isolante (2), la couche semiconductrice structurée (3) et la couche de masquage (4);

   – cette couche de laque photosensible (5) est érodée juste suffisamment pour que la couche de masquage (4) soit entièrement dégagée;
   – cette couche de masquage (4) est totalement éliminée; et
   – les parties résiduelles de la couche de laque photosensible (5) sont également éliminées.

2. Procédé selon la revendication 1, caractérisé en ce que la couche de masquage (4) est constituée de dioxyde de silicium, de nitrure de silicium ou d'un métal.

3. Procédé selon la revendication 1 ou 2, caractérisé en ce que la couche de laque photosensible (5) est érodée et éliminée à l'aide d'un plasma d'oxygène.

4. Procédé selon l'une des revendications 1 à 3, caractérisé en ce que la couche de masquage (4) est éliminée par morsure humide ou au plasma.

Fig. 1

Fig. 2

Fig. 3

Fig. 4

Fig. 5